# EUROPEAN PATENT SPECIFICATION

(11) **EP 0 336 724 B1**
(45) Date of publication and mention of the grant of the patent: **01.10.1997**
(21) Application number: 89303336.5
(22) Date of filing: 04.04.1989
(51) Int. Cl.: C08G 59/14, C09D 163/02

(54) **Process for preparing polyol resins**
Verfahren zur Herstellung von Polyolharzen
Procédé de préparation de résines de polyol

(30) Priority: 04.04.1988 JP 82610/88; 04.04.1988 JP 82611/88
(43) Date of publication of application: 11.10.1989
(73) Proprietor: MITSUI PETROCHEMICAL INDUSTRIES, LTD., Tokyo 100 (JP); Ricoh Company, Ltd, Ohta-ku Tokyo 143 (JP)
(72) Inventor: Nakamura, Hideo, Ichihara-shi Chiba (JP); Wakizaka, Masaru, Ichihara-shi Chiba (JP); Yamamoto, Yohzoh, Ichihara-shi Chiba (JP)
(74) Representative: Cresswell, Thomas Anthony

(56) References cited:
- EP-A- 0 339 773
- CH-A- 443 342
- GB-A- 2 101 605
- DATABASE WPIL, accession no. 86-315306, Derwent Publications Ltd, London, GB; & JP-A-61 233 068 (NIPPON OILS & FATS) 17-10-1986

## Description

This invention relates to a process for preparing a polyol resin substantially free of epoxy groups from an epoxy resin, more specifically to polyol resin which possesses flexibility, high crosslinking reactivity and high storage stability and which is suitably used for a baking type coating material.

Among bisphenol type epoxy resins, those having high molecular weight have considerable amounts of secondary hydroxyl groups in their molecular chains and hence can be considered to be kinds of polyol resins. It has been, therefore, known that bisphenol type high molecular weight epoxy resin is used as the polyol component of a polyurethane paint.

Nevertheless, the coating film finally formed in such a paint is brittle due to the toughness inherent to a bisphenol type epoxy resin. Moreover, coating compositions whose baking cycles are short, that is to say, whose curing time is short, are desirable in setting up an energy-efficient coating process line. Such a polyol component which has a higher reactivity has, therefore, been desired.

Moreover, high molecular weight epoxy resin cannot be used for the coating material which is used in a compounded form with tar or asphalt, since the epoxy groups contained in it, small as they may be in amount, increase the viscosity of the paint over time if the paint is mixed with tar or asphalt, to the extent that the storage stability of the paint is impaired.

The present invention seeks to provide, through resolving the above-mentioned problems, a process for preparing a polyol resin from a bisphenol type epoxy resin as the starting raw material, which polyol resin, when it is used as the polyol component of said coating material, provides a flexible film of coating material with a short curing time and exhibits stability over an extended period of time even when it is mixed with, for example, asphalt or tar.

This invention has been established by the discovery that by at least partly esterifying the secondary or tertiary hydroxyl groups of epoxy resins having epoxy and secondary or tertiary hydroxyl groups and by reacting the terminal epoxy groups with a monovalent phenol compound the hard and brittle epoxy resin is provided with adequate flexibility and at the same time the viscosity does not increase even if, for example, tar or asphalt is compounded therewith, and a high storage stability is achieved.

The present invention provides a process for preparing a polyol resin substantially free of epoxy groups which comprises subjecting a bisphenol type epoxy resin (a) having epoxy and secondary or tertiary hydroxyl groups and having an epoxy equivalent of 150 to 3500 to the following steps (i), (ii) and optionally (iii) in the order (iii), (i), (ii); (i), (iii), (ii) or (iii) simultaneously with (i) followed by (ii):
(i) reacting the epoxy groups with a monovalent phenol compound having 6 to 40 carbon atoms (c) in the presence of a catalyst, optionally in the presence of a bisphenol (d);
(ii) at least partly esterifying the secondary or tertiary hydroxyl groups with at least one of a lactone, monocarboxylic acid or ester of a monocarboxylic acid;
(iii) reacting the epoxy groups with a primary amine (b);
wherein the amounts of said epoxy resin (a) having an epoxy equivalent of X, said optional primary amine (b) having a molecular weight of Mb, said compound (c) having a molecular weight of Mc, and said optional bisphenol (d) having a molecular weight of Md, are in accordance with the following formula (1) and, if said primary amine (b) is used, formula (2):$\text{(1) 0.95 ≦} \frac{\text{A/X}}{\text{2B/Mb + C/Mc + 2D/Md}} \text{≦ 1.05}$$\text{(2) 2000 ≦} \frac{\text{2} \left(\text{A + B+ C + D}\right)}{\text{C/Mc} \left|\text{A/X-2B/Mb-C/Mc-2D/Md}\right|} \text{≦ 15000}$ wherein
A is the amount of epoxy resin (a) in grams;
B is the amount of primary amine (b) in grams;
C is the amount of compound (c) in grams; and
D is the amount of bisphenol (d) in grams.

This invention has also been established by the discovery that by reacting epoxy resins with primary amines to extend the chain length of the epoxy resin, reacting the terminal epoxy groups with a monovalent phenol compound, and thus esterifying the secondary hydroxyl groups as indicated above, the hard and brittle epoxy resin is provided with adequate flexibility and at the same time the reactivity of the secondary hydroxyl groups is increased by the effect imparted by amines used for extending the chain length, and moreover the viscosity does not increase even if, for example, tar or asphalt is compounded therewith, and a high storage stability is achieved.

Thus, in the present invention, the bisphenol type epoxy resin (a) may be subjected to step (iii) such that steps (i), (ii) and (iii) are carried out in the order stipulated above.

The present invention also provides a process as defined above which further comprises formulating the polyol resin produced with an amine resin or isocyanate to form a baking-type coating composition.

The polyol resin in the present invention is derived from a bisphenol type epoxy resin (a), as represented for example by formula (I), which may be prepared by reaction between a bisphenol and a haloepoxide such as epichlorohydrin and β-methylepichlorohydrin. 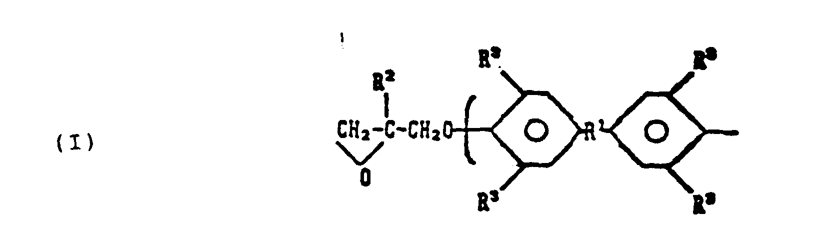 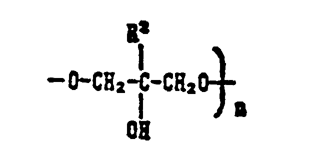 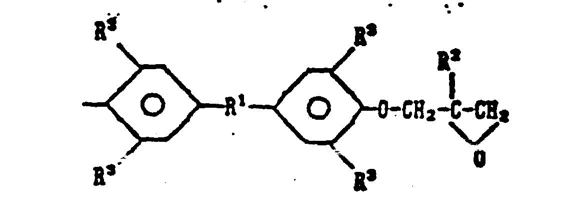 wherein
R¹ is 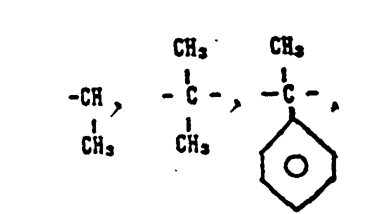 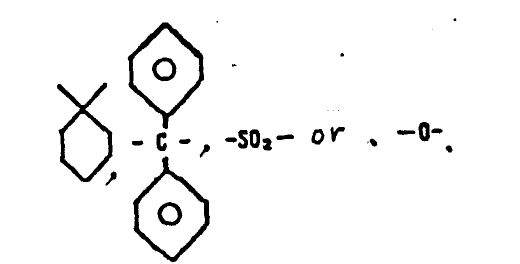
R² is hydrogen or a methyl group;
R³ is hydrogen or a halogen atom; and
n is the number of repeating structural units including zero.

Preferred among these bisphenol type epoxy resins are a glycidyl ether or β-methylglycidyl ether of a bisphenol, which are exemplified as follows:
2,2-bis(hydroxyphenyl)propane(so-called bisphenol A);
bis(4-hydroxyphenyl)methane(so-called bisphenol F); and
1,1-bis(4-hydroxyphenyl)ethane(so-called bisphenol AD).

Among these bisphenol type epoxy resins, the glycidyl ether of 2,2-bis(hydroxyphenyl)propane is specifically preferred.

The bisphenol type epoxy resin (a) has an epoxy equivalent of 150 to 3500, preferably 160 to 2500.

The other compound which is reacted with the epoxy group in step (i) is the monovalent phenol compound having 6 to 40 carbon atoms (c). This compound has an active hydrogen atom in the molecule which is reactive with epoxy group. Examples of the monovalent phenols are phenol, cresol, isopropyl phenol, amyl phenol, nonyl phenol, dodecyl phenol, xylenol and p-cumylphenol.

In step (i) bisphenols (d) may be allowed to coexist and react with the epoxy groups. As such bisphenols those which are represented by the following formula are exemplified: 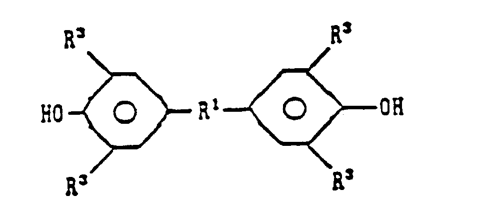 wherein R¹ and R³ as defined above.

The bisphenols which are used therein may preferably, but not necessarily, be the same as the ones used to construct the backbone of the epoxy resin (a).

When step (i) is carried out in coexistence with bisphenols (d), the epoxy resin (a) which is generally used as the starting raw material has an epoxy equivalent of from 150 to 500, and preferably from 160 to 400.

The catalyst which is used in step (i) includes hydroxides of alkali metals, such as sodium hydroxide, potassium hydroxide, lithium hydroxide; alcoholates of alkali metal, such as sodium methylate; alkali metal salts, such as lithium chloride, lithium carbonate and sodium carbonate; tertiary amines, such as dimethylbenzyl amine, triethyl amine, and pyridine; quarternary ammonium salts such as tetramethyl ammonium chloride, and benzyltrimethyl ammonium chloride; methyl iodide adducts of organic phosphorous compounds, such as triphenylphosphine, triethylphosphine; and diethylether complexs of Lewis acids, such as boron trifluoride, aluminum chloride and tin tetrachloride.

The amount of catalyst used varies with the reaction temperature, but is generally 0.01 to 1000 parts by weight per million parts by weight (ppm) of the reaction material, preferably 0.1 to 1000 ppm of the reaction material.

Although the reaction may be carried out without using a solvent, in cases where a solvent is used , a solvent which does not have active hydrogens such as a hydrocarbon, for example toluene and xylene, or ketones, for example methylisobutyl ketone, methylethyl ketone, and cyclohexane is used.

The esterifying agent used in step (ii) for esterifying the secondary or tertiary hydroxyl groups is a lactone, or a monocarboxylic acid or ester thereof.

Such lactones have 3 to 10 carbon atoms, preferably 3 to 8 carbon atoms, among which are preferred β-propiolactone, 6-valerolactone, £-caprolactone, γ-butylolactone, β-butylolactone, and γ-valerolactone. Specifically preferable are γ-butylolactone and ε-caprolactone.

As the monovalent carboxylic acid, the same substances as the monovalent carboxylic acid which has been described in the foregoing as compound (c) may be used, among which those having 6 to 25 carbon atoms are preferred.

As the ester of a monovalent carboxylic acid, a lower alkylester of said carboxylic acid such as a methylester or ethylester may be cited as preferred examples.

In cases where lactones are used as the esterifying agent, the lactones are used to the extent that the amount of polyester being graft polymerized in the finally obtained polyol resin from secondary hydroxyl group as the starting point is generally 0.5 to 30 weight percent, and preferably 2 to 20 weight percent of the polyol resin.

In cases where monocarboxylic acid or its ester is used as the esterifying agent, the monocarboxylic acid or its ester is used to the extent that the amount of ester group in the finally obtained polyol resin is about 0.5 to 30 mole percent, and preferably 1 to 20 mole percent of the total amount of hydroxyl group and ester group in the polyol resin.

The esterification reaction of the secondary or tertiary hydroxyl groups in step (ii) may be carried out without using a catalyst or in the presence of a catalyst at a temperature of 80 to 250 °C, preferably at a temperature of 100 to 200 °C. The reaction time extends to about 3 to 10 hours.

It is desirable that water produced when a monocarboxylic acid is used as the esterifying agent is removed from the system to complete the reaction.

Water can be removed by, for example, Dean-Stark apparatus, or by azeotropic distillation at atmospheric pressure or reduced pressure with a water-insoluble solvent. In cases where no solvent is used, water can be removed by carrying out the reduction at reduced pressure.

When a monocarboxylic acid ester is used as the esterifying agent, the lower alcohol produced in the reaction can be removed from the system by carrying out the reaction at reduced pressure.

Examples of the catalyst which can be used for the esterification reaction are organic or inorganic titanium compounds, such as tetrabutyl titanate, tetraethyl titanate, butoxyl titanium trichloride, titanium tetrachloride; organic or inorganic aluminium compounds, such as triethyl aluminium, ethyl aluminium chloride, aluminium trichloride; organic or inorganic zinc compounds, such as diethyl zinc, zinc chloride; organic or inorganic tin compounds, such as dibutyl tin laurate, tin salt; acids, such as p-toluenesulfonic acid, and phosphoric acid; alkali metals such as lithium and sodium; alkali metal hydroxides, such as lithium hydroxide, sodium hydroxide; alkali metal salts, such as sodium carbonate; lithium acetate and lithium chloride; and tertiary amines, such as triethyl amine and pyridine.

These catalysts are used in a ratio of 0.01 to 1000 ppm, preferably 0.1 to 500 ppm, relative to the amount of resin.

Examples of the solvent used in the reaction are toluene, xylene, methylisobutyl ketone, methylethyl ketone, and cyclohexane although no solvent may be used.

In the present invention an epoxy resin from which epoxy groups have been substantially eliminated is obtained first by step (i), and then step (ii) is carried out.

The novel polyol resin thus prepared does not substantially contain epoxy groups. Generally its hydroxyl value is about 150 to 250 KOH mg/g and its softening point is about 70 to 180 °C. Its number average molecular weight is generally 2000 to 15000.

The polyol resin can be used for a baking type coating material compounded with an amine resin such as melamine resin, or a coating material dried at room temperature or a baking type coating material compounded with an isocyanate or block isocyanate.

The polyol resin can be also used as a modifying agent by compounding with another polyol resin, such as a polyester polyol or acrylpolyol; polyethers, such as polyethylene glycol or polypropylene glycol; polyester resin; or polyacrylate resin.

In using it for various applications, it can be co-used with, for example, an inorganic or organic filler or pigment, such as talc, calcium carbonate, silica, carbon, tar, and asphalt, as the conditions may require.

The other polyol resin in the present invention is also derived from a bisphenol type epoxy resin (a), as for example represented by formula (I).

The polyol resin is obtained following steps (i), (ii) and (iii) as defined above.

Exemplified in the following are primary amines (b) which are reacted with the epoxy group of the epoxy resin (a) in step (iii):
(1) aliphatic primary amines such as propyl amine, butyl amine, hexyl amine, octyl amine, laurylamine, stearyl amine, palmityl amine, and oleyl amine, among which those having at least 6 carbon atoms, and 12 to 20 carbon atoms are most preferred;
(2) aromatic primary amines, such as aniline, toludine, xylidine, cumidine, hexyl aniline, nonyl aniline, and dodecyl aniline, among which those having a C₃₋₂₀ alkyl group attached to the benzene ring of aniline are preferred;
(3) cycloaliphatic primary amines such as cyclopentyl amine, cyclohexyl amine, and norbornyl amine, among which those having 6 to 20 carbon atoms are preferred; and
(4) aromatic nuclear substituted aliphatic primary amines such as benzyl amine, phenethyl amine, 4-phenyl-3-methylbutyl amine, and cinnamyl amine, among which those having 7 to 15 carbon atoms are preferred.

Preferred among these primary amines (b) are aliphatic primary amines having 8 to 20 carbon atoms.

The amount of primary amine (b) used generally ranges from 0.05 to 50 parts by weight, preferably from 0.1 to 20 parts by weight, per 100 parts by weight of bisphenol type epoxy resin (a) in view of the reactivity of the polyol resin of the present invention and the toughness of the coating film achieved when it is used in the coating material.

In step (iii) bisphenols may be allowed to coexist and react with the epoxy groups. Such bisphenols are the same bisphenols as described above in step (i).

The amounts of primary amine (b) which is used in step (iii) and the compound (c) which is used in step (i) are sufficient to fulfill formulae (1) and (2) given above. In formula (2), it is preferred that:$\text{3000 ≦} \frac{\text{2} \left(\text{A + B+ C + D}\right)}{\text{C/Mc+} \left|\text{A/X-2B/Mb-C/Mc-2D/Md}\right|} \text{≦ 10000}$

In cases where lactones are used as the esterifying agent, the lactones are also used to the extent that the amount of polyester being graft polymerized in the finally obtained polyol resin from secondary or tertiary hydroxyl group as the starting point is generally 0.5 to 30 weight percent, and preferably 2 to 20 weight percent of the polyol resin.

In cases where monocarboxylic acid or its ester is used as the esterifying agent, the monocarboxylic acid or its ester is also used to the extent that the amount of ester group in the finally obtained polyol resin is about 0.5 to 30 mole percent, and preferably 1 to 20 mole percent of the total amount of hydroxyl group and ester group in the polyol resin.

The reaction between the epoxy group and the primary amine (b) in step (iii) may be carried out either in the presence of a catalyst or in the absence of a catalyst at a temperature of 50 to 250 °C, preferably at a temperature of 100 to 200 °C. The reaction time is 2 to 5 hours.

The catalyst which is used in step (iii) is the same catalyst which is used in step (i) as described above.

The amount of catalyst used varies with the reaction temperature, but is generally 0.01 to 1000 parts by weight per million parts by weight (ppm) of the reaction material, preferably 0.1 to 1000 ppm of the reaction material.

Although the reaction may be carried out without using a solvent, in cases where a solvent is used, a solvent which does not have active hydrogens such as a hydrocarbon, for example, toluene and xylene, and a ketone, for example, methylisobutyl ketone, methylethyl ketone, and cyclohexane, is used.

When step (iii) is carried out, the catalyst used in the esterification reaction (ii) is preferably used in an amount of 0,12 to 500 ppm of the resin.

The polyol resin thus prepared does not substantially contain epoxy groups. Generally its hydroxyl value is about 150 to 250 KOH mg/g and its softening point is about 70 to 180 °C. Its number average molecular weight is 2000 to 15000.

The polyol resin of the present invention can be used for a baking type coating material compounded with amine resin such as melamine resin, or a coating material dried at room temperature or a baking type coating material compounded with isocyanate or block isocyanate.

The polyol resin of the present invention can be also used as a modifying agent by compounding with another polyol resin, such as polyester polyol or acrylpolyol; polyethers, such as polyethylene glycol, polypropylene glycol; polyester resin; and polyacrylate resin.

In using it for various applications, it can be co-used with, for example, an inorganic or organic filler or pigment, such as talc, calcium carbonate, silica, carbon, tar, and asphalt, according to the conditions required.

### EXAMPLES

Examples of the present invention are given below by way of illustration.

in the Examples, the epoxy equivalents and hydroxyl value were determined as described below.

### [Evaluation of Epoxy Equivalents]

1. 0.2 g to 10 g of the resin is measured into a 20-ml Erlenmeyer flask, and 25 ml of dioxane is added to make a solution.
2. Precisely, 25 ml of 0.2N hydrochloric acid solution (dioxane solution) is added to the Erlenmeyer flask. The flask is sealed. After thoroughly mixing the contents in the sealed flask, the flask is allowed to stand for 30 minutes.
3. After adding 50 ml of a toluene-ethanol mixed solution (1/1 volume ratio) to the solution, the resulting solution is titrated with 0.1N sodium hydrxide solution, using cresol red as the indicator.
4. The epoxy equivalent is calculated by the following equation:$\text{X =} \frac{\text{W x 1000}}{\left(\text{Q - S}\right) \text{x 0.1 x f}}$
wherein:
W is the weight of the resin sample in grams,
S is the volume in ml of 0.1 N sodium hydroxide added,
f is the factor of 0.1N sodium hydroxide, and
Q is the volume in ml of 0.1N sodium hydroxide solution titrated in a blank test.

### [Evaluation of Hydroxyl Value]

1. 1.5 to 2.0 g of the resin is measured into a 25-ml volumetric flask and purified chloroform (after having ethanol and water removed with molecular sieve 4A) is added to make a solution. After the resin has been completely dissolved, the volumetric flask is filled up to the 25-ml level.
2. Absorbance of the sample filled in a 0.2 mm thick KBr liquid cell is measured on the 4000 m⁻¹ to 3000 m⁻¹ band, using purified chloroform as the reference.
3. The absorbances of two absorption peaks, T₁ and T₂, are computed on the basis of the base absorbance as the standard (zero). Then, the concentration of hydroxyl group (eq/l) is obtained from the values of T₁ + T₂ with reference to a calibration curve prepared in advance. The obtained concentration of hydroxyl group is converted into the hydroxyl value by the following equation:$\text{Hydroxyl value (mg/g) =} \frac{\left(\text{Concentration of hydroxyl group/4}\right) \text{x 56.1 x F}}{\text{Weight of the sample} \left(\text{g}\right)} \text{x 100}$
wherein:F is the compensation for the thickness of the cell (F = L₁ / L₂)
- L₁ =: The thickness of the cell used in preparation of the calibration curve (mm)
- L₂ =: The thickness of the cell used in the measurement (mm)

### [Preparation of the Calibration Curve]

1. 0.1 g, 0.2 g, 0.3 g, 0.4 g, 0.5 g, and 0.6 g of purified diethylene glycol dehydrated with a molecular sieve are measured into 25-ml Erlenmeyer flasks respectively, and each flask is filled up to the 25-ml level with purified chloroform.
   These are standard liquids having hydroxyl equivalents of 0.075, 0.151, 0.226, 0.301, 0.376, and 0.452 eq/l.
2. Absorbances of these standard liquids are measured on the 4000 to 3000 cm⁻¹ band, using a KBr liquid cell (0.2 mm).
3. The absorbances of two absorption peaks, T₁ and T₂, are computed on the basis of the base absorbance as the standard. Then, the relationship between the T₁ + T₂ value and the hydroxyl equivalent is plotted as a calibration curve.

### Example 1

A 1-liter separable flask equipped with a stirrer, a thermometer, a nitrogen inlet, and a condenser was charged with 200 g of bisphenol A type epoxy resin, having an epoxy equivalent of 187 g/eq, 109.7 g of bisphenol A, 20.8 g of p-cumylphenol, and 50 ml of xylene.

The contents were heated in nitrogen atomosphere and 0.3 ml of aqueous solution of lithium chloride was added as the temperature reached 70 °C. Then, the contents were heated to 185 °C, during which period xylene was stripped off at reduced pressure. By agitating the contents at a pressure of 5 mmHg (666Pa) and at a temperature of 185 °C for 1 hour, xylene was completely removed.

After restoring the pressure, the reaction was carried out for 5 hours. 17.4 g of ε-caprolactone was added, and the reaction was carried out for 6 hours at 185 °C, and a resin having an OH value of 201 KOH mg/g was obtained. The obtained resin was diluted with a solvent prepared by mixing equal weights of methylisobutyl ketone and toluene to the nonvolatile concentration of 45.0%.

The thus obtained polyol resin was evaluated with respect to the following items in the form of a cured coating film prepared by compounding it with a polyurethane resin (Takenate D-102 manufactured by Takeda Pharmaceutical Co.) at an NCO/OH equivalent ratio of 0.8.

### (1) Drying property

A mixture of polyol resin and polyurethane resin was applied to the surface of a 2 mm thick glass plate to the extent that a 500 micron coating film was formed. The lapse of time up to the point when the needle of the RI tester (manufactured by Nippon Rigaku Kogyo) no longer penetrates the wet coating film at 20 °C was defined as the "semi-cured time."

### (2) Tensile Strength and Elongation

A mixture of polyol resin and polyurethane resin was applied to the polished surface of carbon steel (SS41), upon which mold release agent had been sprayed, to yield a 400 micron thick wet coating film. The thus prepared film was allowed to stand at room temperature for 33 hours, and, then, was heated at 60 °C for 24 hours into a cured film. After removing the film from the carbon steel plate, test specimens of Pattern No.2 of JIS K-7113 were cut out.

Tensile strength and elongation of the film were measured, using said specimens, by tensile tests, according to JIS K-7113. The crosshead speed was set at 1 mm/min on the Tensilon testing apparatus.

The results of the test are shown in Table 1.

### Example 2

Using the same apparatus as described in Example 1, 250 g of bisphenol A type epoxy resin, having an epoxy equivalent of 187 g/eq, 136.8 g of bisphenol A, 27.0 g of p-nonylphenol, and 50 ml of xylene were added. The contents of the flask were heated in a nitrogen atmosphere, and 0.4 ml of 5N aqueous solution of lithium chloride was added as the temperature of the contents reached 70 °C. Then, the contents of the flask were heated to a temperature of 185 °C, during which period xylene was stripped off at reduced pressure. By agitating the contents at a pressure of 5 mmHg (666Pa) and at a temperature of 185 °C for 1 hour, xylene was completely removed.

After restoring the pressure, the reaction was carried out for 5 hours. 21.5 g of £-caprolactone was added, and the reaction was carried out for 6 hours at 185 °C and a resin having an OH value of 208 KOH mg/g was obtained.

The obtained resin was diluted with a solvent prepared by mixing equal weights of methylisobutyl ketone and toluene to the nonvolatile concentration of 45.2%.

Using a solution of this resin, a film was made and evaluation was carried out in the same procedure as in Example 1.

The results of such evaluation are shown in Table 1.

### Comparative Example 1.

The procedure of Example 1 was repeated except that a bisphenol A type solid epoxy resin, having an epoxy equivalent of 2550 g/eq and a softening point of 141 °C, is employed instead of the polyol.

The evaluation of the performance of film was carried out in the same procedure as in Example 1.

The results are shown in Table 1.

**Table 1**

| | Example 1 | Example 2 | Comparative Example 1 |
|---|---|---|---|
| Semi-cured time, hr | 6.4 | 6.6 | 13.1 |
| Tensile strength, kgf/mm² | 5.4 | 5.2 | 4.3 |
| Tensile modulus, kgf/mm² | 133 | 120 | 145 |
| Elongation, % | 7.2 | 7.5 | 4.0 |

Those polyol resins prepared in accordance with the above-mentioned Examples possess flexibility, high curing reactivity and high storage stability.

### Examples 3 and 4

A 5-liter separable flask equipped with a stirrer, a thermometer, a nitrogen inlet, and a condenser was charged with bisphenol A type epoxy resin, having an epoxy equivalent of 187 g/eq, bisphenol A, monovalent phenol compounds in the quantities indicated in Table 2 and 250 ml of xylene. The contents were heated to a temperature of 150 °C, during which period water and xylene were stripped off at reduced pressure. By agitating the contents at a pressure of 5 mmHg (666Pa) and at a temperature of 150 °C for 1 hour, xylene was completely removed.

After restoring the pressure, a primary amine in the quantity indicated in Table 2 was added, and the reaction was carried out for 5 hours at 185 °C. Afterwards, ε-caprolactone in the quantity indicated in Table 2 was added and the reaction was carried out for 6 hours to obtain the polyol resins having the hydroxyl value as indicated in Table 2. Upon completion of the reaction, the obtained polyol resin was diluted with a solvent prepared by mixing equal weights of methylisobutyl ketone and toluene, and the nonvolatile content was as shown in Table 2.

**Table 2**

| | Example 3 | Example 4 |
|---|---|---|
| Bisphenol A type epoxy resin, g | 2,000 | 2,102.6 |
| Bisphenol A, g | 1,082.5 | 1,166.4 |
| Monovalent phenol compound, g | p-cumylphenol 150 | p-nonylphenol 218.5 |
| Primary amine, g | stearylamine (Farmin 80) 96.3 | cyclohexylamine 12.4 |
| Esterification agent, g | ε-caprolactone 175.2 | ε-caprolactone 184.2 |

| Product | | |
|---|---|---|
| hydroxyl value, KOH mg/g | 215 | 210 |
| non-volatile content, % | 45.1 | 45.0 |

The thus obtained polyol resin was evaluated with respect to the items described in Example 1, in the form of a cured coating film prepared by compounding it with polyurethane resin (Takenate D-102 manufactured by Takeda Pharmaceutial Co.) at an NCO/OH equivalent ratio of 0.8.

The results of the test are shown in Table 3.

### Example 5

A 5-liter separable flask equipped with a stirrer, a thermometer, a nitrogen inlet, and a condenser was charged with 2186.3 g of bisphenol A type epoxy resin, having an epoxy equivalent of 187 g/eq, 1105.4 g of bisphenol A and 250 ml of xylene. The contents of the flask were heated in nitrogen atmosphere, and 0.6 ml of 5N aqueous solution of lithium chloride was added as the temperature of the contents reached 70 °C. Then, the contents of the flask were heated to a temperature of 150 °C, during which period xylene was stripped off at reduced pressure. By agitating the content at a pressure of 5 mmHg (666Pa) and at a temperature of 150 °C for 1 hour, xylene was completely removed.

After restoring the pressure, 92.5 g of phenol and 115.8 g of laurylamine (Farmin 20D manufactured by Kao K.K.) were added, and the reaction was carried out for 5 hours at 185 °C. Afterwards, 184.2 g of £-caprolactone was added and the reaction was carried out for 6 hours to obtain a resin having a hydroxyl value of 230 KOH mg/g. The thus obtained resin was diluted with a solvent prepared by mixing equal amounts of methylisobutyl ketone and toluene. The solution of the resin was used to prepare a coating film in the same procedure in Example 1. Results of the test to evaluate the performance of the film are given in Table 3.

### Example 6

A 1-liter separable flask equipped with a stirrer, a thermometer, a nitrogen inlet, and a condenser was charged with 250 g of bisphenol A type epoxy resin, having an epoxy equivalent of 187 g/eq, 135.5 of bisphenol A, 18.6 g of p-cumylphenol and 50 ml of xylene. The contents of the flask were heated in nitrogen atmosphere, and 1 ml of 1.7N aqueous solution of lithium chloride was added as the temperature of the contents reached 70 °C. Then, the contents of the flask were heated to a temperature of 150 °C, during which period xylene was stripped off at reduced pressure. By agitating the content at a pressure of 5 mmHg (666Pa) and at a temperature of 150 °C for 1 hour, xylene was completely removed.

After restoring the pressure, 11.8 g of stearyl amine (Farmin 80 manufactured by Kao K.K.) was added, and the reaction was carried out for 5 hours at 185 °C. Afterwards, a Dean-Stark apparatus was attached to the reactor, and 21.9 g of stearic acid and 30 ml of xylene were added to the contents, and the esterification reaction was carried out in refluxing xylene at 180 to 190 °C for 6 hours. In order to carry out the xylene flux smoothly, an additional quantity of xylene was added to the contents as the reaction temperature exceeded 190 °C. The water produced in the reaction was subjected to azeotropic distillation with xylene, and was removed from the system by means of separation by the Dean-Stark apparatus. Upon completion of the esterification reaction, xylene was stripped off at 190 °C at reduced pressure, and a resin having a softening point of 146 °C and a hydroxyl value of 205 KOH mg/g was obtained. This resin was diluted with a mixed solvent prepared by mixing equal amounts of methylisobutyl ketone and toluene to a nonvolatile concentration of 44.9%.

The solution of the resin was used to prepare a film to coating in the same procedure as in Example 3. Results of the test to evaluate the performance of the film are given in Table 3.

**Table 3**

| | Example 3 | Example 4 | Example 5 | Example 6 | Comparative Example 1 |
|---|---|---|---|---|---|
| Semi-cured time, hr | 2.6 | 5.3 | 2.3 | 6.9 | 13.1 |
| Tensile strength, kgf/mm² | 5.8 | 4.8 | 5.3 | 5.5 | 4.3 |
| Tensile modulus, kgf/mm² | 136 | 121 | 127 | 134 | 145 |
| Elongation, % | 6.9 | 8.5 | 6.7 | 6.3 | 4.0 |

The polyol resins prepared in accordance with the above-mentioned Examples possess flexibility, high curing reactivity and high storage stability when used for the coating application.

## Claims

1. A process for preparing a polyol resin substantially free of epoxy groups which comprises subjecting a bisphenol type epoxy resin (a) having epoxy and secondary or tertiary hydroxyl groups and having an epoxy equivalent of 150 to 3500 to the following steps (i), (ii) and optionally (iii) in the order (iii), (i), (ii); (i), (iii), (ii) or (iii) simultaneously with (i) followed by (ii):
(i) reacting the epoxy groups with a monovalent phenol compound having 6 to 40 carbon atoms (c) in the presence of a catalyst, optionally in the presence of a bisphenol (d);
(ii) at least partly esterifying the secondary or tertiary hydroxyl groups with at least one of a lactone, monocarboxylic acid or ester of a monocarboxylic acid;
(iii) reacting the epoxy groups with a primary amine (b),
wherein the amounts of said epoxy resin (a) having an epoxy equivalent of X, said optional primary amine (b) having a molecular weight of Mb, said compound (c) having a molecular weight of Mc, and said optional bisphenol (d) having a molecular weight of Md, are in accordance with the following formula (1) and, if said primary amine (b) is used, formula (2):$\text{(1) 0.95 ≦} \frac{\text{A/X}}{\text{2B/Mb + C/Mc + 2D/Md}} \text{≦ 1.05}$$\text{(2) 2000 ≦} \frac{\text{2} \left(\text{A + B+ C + D}\right)}{\text{C/Mc+} \left|\text{A/X-2B/Mb-C/Mc-2D/Md}\right|} \text{≦ 15000}$ wherein
A is the amount of epoxy resin (a) in grams;
B is the amount of primary amine (b) in grams;
C is the amount of compound (c) in grams; and
D is the amount of bisphenol (d) in grams.

2. A process according to claim 1 wherein the lactone in step (ii) is used in an amount such that the resulting polyol resin contains from 0.5 to 30 weight percent of lactone polymer (polyester).

3. A process according to claim 1 wherein the monocarboxylic acid or ester of a monocarboxylic acid is used in an amount such that from 0.5 to 30 mole percent of the hydroxyl groups are esterified.

4. A process according to any one of the preceding claims wherein the bisphenol type epoxy resin (a) is subjected to step (iii) wherein the amounts of said epoxy resin (a), primary amine (b), compound (c) and optional bisphenol (d), are such that:$\text{3000 ≦} \frac{\text{2} \left(\text{A + B+ C + D}\right)}{\text{C/Mc+} \left|\text{A/X-2B/Mb-C/Mc-2D/Md}\right|} \text{≦ 10000}$ wherein A, X, B, Mb, C, Mc, D and Md are as defined in claim 1.

5. A process according to any one of the preceding claims which further comprises formulating the polyol resin produced with an amine resin or isocyanate to form a baking-type coating composition.

## Patentansprüche

1. Verfahren zur Herstellung eines Polyolharzes, das im wesentlichen frei ist von Epoxygruppen, umfassend die Behandlung eines Epoxyharzes vom Bisphenoltyp (a) mit Epoxy- und sekundären oder tertiären Hydroxylgruppen und mit einem Epoxyäquivalent von 150 bis 3500 durch die folgenden Stufen (i), (ii) und gegebenenfalls (iii) in der Reihenfolge (iii), (i), (ii) ; (i) , (iii), (ii) oder (iii) gleichzeitig mit (i) und anschließend (ii):
(i) Umsetzen der Epoxygruppen mit einer einwertigen Phenolverbindung mit 6 bis 40 Kohlenstoffatomen (c) in Gegenwart eines Katalysators und gegebenenfalls in Gegenwart eines Bisphenols (d);
(ii) mindestens teilweises Verestern der sekundären oder tertiären Hydroxylgruppen mit mindestens einer Verbindung eines Lactons, einer Monocarbonsäure oder eines Esters einer Monocarbonsäure;
(iii) Umsetzen der Epoxygruppen mit einem primären Amin (b);
wobei die Mengen des Epoxyharzes (a) mit einem Epoxyäquivalent von X, des gegebenenfalls vorhandenen primären Amins (b) mit einem Molekulargewicht von Mb, der Verbindung (c) mit einem Molekulargewicht von Mc und des gegebenenfalls vorhandenen Bisphenols (d) mit einem Molekulargewicht von Md der folgenden Formel (1) und, wenn das primäre Amin (b) verwendet wird, der Formel (2) entsprechen:$\text{(1) 0,95 ≦} \frac{\text{A/X}}{\text{2B/Mb + C/Mc + 2D/Md}} \text{≦ 1,05}$$\text{(2) 2000 ≦} \frac{\text{2} \left(\text{A + B+ C + D}\right)}{\text{C/Mc+} \left|\text{A/X-2B/Mb-C/Mc-2D/Md}\right|} \text{≦ 15000}$ wobei
A die Menge an Epoxyharz (a) in Gramm ist,
B die Menge an primärem Amin (b) in Gramm ist,
C die Menge an Verbindung (c) in Gramm ist, und
D die Menge an Bisphenol (d) in Gramm ist.

2. Verfahren nach Anspruch 1, wobei das Lacton in Stufe (ii) in einer solchen Menge verwendet wird, daß das erhaltene Polyolharz 0,5 bis 30 Gew.-% Lactonpolymer (Polyester) enthält.

3. Verfahren nach Anspruch 1, wobei die Monocarbonsäure oder der Ester einer Monocarbonsäure in einer solchen Menge verwendet wird, daß 0,5 bis 30 Mol-% der Hydroxylgruppen verestert werden.

4. Verfahren nach einem der vorangehenden Ansprüche, wobei das Epoxyharz vom Bisphenoltyp (a) der Stufe (iii) unterworfen wird, wobei die Mengen an Epoxyharz (a), primärem Amin (b), Verbindung (c) und gegebenenfalls Bisphenol (d) so sind, daß$\text{3000 ≦} \frac{\text{2} \left(\text{A + B+ C + D}\right)}{\text{C/Mc+} \left|\text{A/X-2B/Mb-C/Mc-2D/Md}\right|} \text{≦ 10000}$ ist, wobei A, X, B, Mb, C, Mc, D und Md wie in Anspruch 1 definiert sind.

5. Verfahren nach einem der vorangehenden Ansprüche, umfassend ferner die Formulierung des hergestellten Polyolharzes mit einem Aminharz oder Isocyanat zur Herstellung einer Überzugsmasse vom Einbrenntyp.

## Revendications

1. Procédé de préparation d'une résine de polyol pratiquement exempte de groupes époxy, dans lequel on fait subir à une résine époxy de type bisphénol (a), possédant des groupes époxy et des groupes hydroxyle secondaires ou tertiaires et ayant un équivalent époxyde de 150 à 3 500, les étapes (i), (ii) et éventuellement (iii) suivantes, dans l'ordre (iii), (i), (ii) ou bien (i), (iii), (ii) ou bien (iii) en même temps que (i), puis (ii):
(i) faire réagir les groupes époxy avec un composé monophénolique (c) ayant 6 à 40 atomes de carbone, en présence d'un catalyseur, éventuellement en présence d'un bisphénol (d),
(ii) estérifier au moins partiellement les groupes hydroxyle secondaires ou tertiaires avec au moins un composé choisi parmi les lactones, les acides monocarboxyliques et les esters d'acide monocarboxylique,
(iii) faire réagir les groupes époxy avec une amine primaire (b),
les quantités de ladite résine époxy (a) ayant un équivalent époxyde X, de ladite amine primaire éventuelle (b) ayant une masse moléculaire Mb, dudit composé (c) ayant une masse moléculaire Mc, et dudit bisphénol éventuel (d) ayant une masse moléculaire Md, vérifiant la formule (1) suivante et, si ladite amine primaire (b) est utilisée, la formule (2) suivante :$\text{(1) 0,95 ≦} \frac{\text{A/X}}{\text{2B/Mb + C/Mc + 2D/Md}} \text{≦ 1,05}$$\text{(2) 2000 ≦} \frac{\text{2} \left(\text{A + B+ C + D}\right)}{\text{C/Mc+} \left|\text{A/X-2B/Mb-C/Mc-2D/Md}\right|} \text{≦ 15000}$ formules dans lesquelles
A désigne la quantité de résine époxy (a) en grammes,
B désigne la quantité d'amine primaire (b) en grammes,
C désigne la quantité de composé (c) en grammes, et
D désigne la quantité de bisphénol (d) en grammes.

2. Procédé selon la revendication 1, dans lequel la lactone est utilisée dans l'étape (ii) en une quantité telle que la résine de polyol résultante contient de 0,5 à 30% en poids de polymère de lactone (polyester).

3. Procédé selon la revendication 1, dans lequel on utilise l'acide monocarboxylique ou l'ester d'acide monocarboxylique en une quantité telle que 0,5 à 30% en moles des groupes hydroxyle sont estérifiés.

4. Procédé selon l'une quelconque des revendications précédentes, dans lequel on fait subir à la résine époxy de type bisphénol (a) l'étape (iii), les quantités de ladite résine époxy (a), d'amine primaire (b), de composé (c) et de bisphénol éventuel (d) étant telles que :$\text{3000 ≦} \frac{\text{2} \left(\text{A + B+ C + D}\right)}{\text{C/Mc+} \left|\text{A/X-2B/Mb-C/Mc-2D/Md}\right|} \text{≦ 10000}$ A, X, B, Mb, C, Mc, D et Md étant tels que définis dans la revendication 1.

5. Procédé selon l'une quelconque des revendications précédentes, qui comprend en outre la combinaison de la résine de polyol produite avec une résine d'amine ou un isocyanate pour former une composition de revêtement du type à cuisson.
